(19) Europäisches Patentamt
European Patent Office
Office européen des brevets

(11) **EP 3 059 740 A1**

(12) **EUROPEAN PATENT APPLICATION**
published in accordance with Art. 153(4) EPC

(43) Date of publication:
**24.08.2016 Bulletin 2016/34**

(51) Int Cl.:
*H01B 5/02* (2006.01)        *B22F 1/00* (2006.01)
*B22F 3/10* (2006.01)        *B22F 5/10* (2006.01)
*B22F 9/00* (2006.01)        *H01B 5/14* (2006.01)
*H01B 13/00* (2006.01)        *H01L 21/52* (2006.01)
*B22F 1/02* (2006.01)

(21) Application number: **14854309.3**

(22) Date of filing: **06.10.2014**

(86) International application number:
**PCT/JP2014/076660**

(87) International publication number:
**WO 2015/056589 (23.04.2015 Gazette 2015/16)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority:   **17.10.2013   JP 2013216150**

(71) Applicant: **DOWA Electronics Materials Co., Ltd.
Tokyo 101-0021 (JP)**

(72) Inventors:
• **KURITA Satoru
  Tokyo 101-0021 (JP)**
• **ENDOH Keiichi
  Tokyo 101-0021 (JP)**
• **MIYOSHI Hiromasa
  Tokyo 101-0021 (JP)**

(74) Representative: **Schmidbauer, Andreas Konrad
Wagner & Geyer Partnerschaft
Patent- und Rechtsanwälte
Gewürzmühlstrasse 5
80538 München (DE)**

(54) **JOINING SILVER SHEET, METHOD FOR MANUFACTURING SAME, AND METHOD FOR JOINING ELECTRONIC PART**

(57)     [Problem] To provide a joining silver sheet that is capable of providing a high joining strength with a low pressure of 3 MPa or lower.

[Means for Resolution] A joining silver sheet containing silver particles having a particle diameter of from 1 to 250 nm integrated by sintering, and having a capability of further undergoing sintering on heating and retaining the silver sheet at a temperature range of from $T_A$ to $T_B$ (°C) satisfying $270 \leq T_A < T_B \leq 350$. The silver sheet may be manufactured by a method of subjecting a coated film of a silver paste containing silver powder containing silver particles having a particle diameter of from 1 to 250 nm, and a dispersion medium that undergoes volatilization in a temperature range of 200°C or lower, which are mixed with each other, to a heat treatment at a temperature range, at which no sintering occurs, and then baking at a temperature of from 170 to 250°C under application of a pressure of from 5 to 35 MPa.

**Description**

Technical Field

The present invention relates to a sheet of metallic silver used as a joining material, and a method for manufacturing the same. The invention also relates to a method for joining an electronic part and a substrate by using the sheet.

Background Art

As a method for joining an electronic part, such as a semiconductor chip, to a substrate, in addition to a method using a brazing filler metal, such as solder, a method using a paste containing metal fine powder has been known. Metal nanoparticles having a particle diameter of approximately 100 nm or less can be sintered at a temperature that is largely lower than the melting point of the metal, and therefore, members can be joined to each other by utilizing the sintering phenomenon by coating the paste for sintering to the members to be joined and then baking at a prescribed temperature. For example, PTL 1 discloses a joining material (paste) containing silver fine powder.

Citation List

Patent Literature

PTL 1: WO 2012/169076

Summary of Invention

Technical Problem

The joining material of PTL 1 is useful, for example, in a method of coating the joining material as a circuit pattern corresponding to the part arrangement by printing on an electronic part mounting board or the like. However, since the joining material is coated directly on a member that is used in the final product (for example, an electronic part mounting board), the equipment specifications for all the steps including coating, drying and baking are necessarily adapted to respective product members, and therefore there has been a demand for a more reasonable measure for coping quickly with various products.

On the other hand, by employing such a joining method that a joining material in the form of a sheet produced in advance is inserted between members to be joined, followed by baking, instead of a joining material that is coated on a product member, the aforementioned step of coating the joining material can be omitted, and thereby the process of handling the product member can be rationalized. As the joining sheet, a sheet of a brazing filler metal, such as solder, has been subjected to practical use, and in addition, a metal sheet assuming the use of solid phase diffusion, and a sheet containing particles of metal fine powder bound with a binder assuming the use of sintering may be considered.

The sheet of a brazing filler metal, such as solder, is insufficient in heat resistance of the joined portion in some purposes due to the low melting point of the brazing filler metal. Furthermore, the members to be joined are liable to suffer warpage on joining in the case where one of the members to be joined is a relatively thick metal member, such as a heatsink.

The metal sheet utilizing the solid phase diffusion may achieve a joined portion having higher heat resistance than the solder joining. However, for utilizing the solid phase diffusion, it is necessary to apply a high pressure between the members to be joined under a high temperature. Accordingly, the metal sheet is not suitable for joining electronic parts.

The sheet containing particles of metal fine powder bound with a binder may be capable of joining at a lower temperature than the solid phase diffusion, but for securing a sufficient contact area with the members to be joined, such a high pressure as 10 MPa or higher is required. A too low pressure may reduce the strength of the joined portion. It is not necessarily easy to apply a high pressure to an electronic part and the like, and thus there is a significant limitation in the application thereof. Furthermore, the baking for joining is performed in the state where the binder resin is contained, and thus the joined portion is liable to contain voids, which may be a factor that is disadvantageous for securing the strength of the joined portion. Moreover, it may be considered that the volatilized binder resin adversely affects the electronic part.

An object of the invention is to provide a joining silver sheet that is capable of providing a high joining strength with a low pressure. Another object thereof is to provide a method for joining an electronic part using the same.

Solution to Problem

As a result of detailed investigations, the present inventors have found that the use of a silver sheet that is a sheet containing silver fine powder integrated by sintering in advance and has a capability of further undergoing a sintering phenomenon enables joining through solid phase diffusion under a low pressure.

Specifically, the objects can be achieved by a silver sheet containing silver particles having a particle diameter of from 1 to 250 nm, and preferably silver particles having a particle diameter of from 20 to 120 nm, integrated by sintering, and having a capability of further undergoing sintering on heating and retaining the silver sheet at a temperature range of "$T_A$ (°C) or higher and $T_B$ (°C) or lower" satisfying the following expression (1). It is effective that both surfaces of the sheet each have an arithmetic average surface roughness Ra of 0.10 $\mu$m or less.

$$270 \leq T_A < T_B \leq 350 \tag{1}$$

The silver sheet has voids that are inherent to a sintered body. The "capability of further undergoing sintering" may be confirmed by investigating as to whether or not the shape of the voids is changed on subjecting the silver sheet to an experiment of heating the sheet to a temperature $T_3$ (°C) within a temperature range of $T_A$ (°C) or higher and $T_B$ (°C) or lower. It is preferred that the silver sheet has the capability of further undergoing sintering to such an extent that within a period of time where a heat retention time at a temperature $T_3$ is 5 minutes or less, the change in shape of the voids is observed before and after heating. Specifically, the silver sheet preferably has a "capability of further undergoing sintering on heating and retaining the silver sheet for 5 minutes at a temperature $T_3$ (°C) within the aforementioned temperature range under application of a surface pressure of 1 MPa". It is sufficient that the temperature range of "$T_A$ (°C) or higher and $T_B$ (°C) or lower", at which the sheet further undergoes sintering, is present in a range of from 270 to 350°C, and the capability may not be necessarily observed over the entire range of from 270 to 350°C.

The change in shape of the voids may be observed, for example, by comparing SEM micrographs at a magnification of 30,000 before and after the heating test. In the case where an apparent change in shape of the voids is observed thereby, it is apparent that the sheet has the "capability of further undergoing sintering". As a measure for strict investigation, such a measure is effective that the SEM micrographs before and after heating are compared at the same position determined by marking with a cone-shaped impression. In the case where it is unclear as to whether or not a change in shape of the voids occurs by the measure, it may be determined that the sheet does not have the "capability of further undergoing sintering", and in the other cases, it may be determined that the sheet as the "capability of further undergoing sintering".

The silver sheet preferably has a thickness, for example, in a range of from 10 to 120 $\mu$m in terms of a thickness measured with a flat head micrometer. The flat head micrometer means a micrometer that has a flat shape on both the measurement surfaces of the anvil and the spindle. The shape of the silver sheet includes various shapes, as far as the sheet contains silver fine powder integrated by sintering. For example, a sheet having a projected shape viewed in the thickness direction that shows a pattern formed by printing is encompassed by the invention. The "projected shape" referred herein means a shape that is determined by the contour of the objective item on viewing the item in one direction at infinity.

As a method for manufacturing the silver sheet, such a manufacturing method is provided that contains:

a step of coating, on a substrate, a silver paste containing silver powder containing silver particles having a particle diameter of from 1 to 250 nm, and a dispersion medium having a 25% volatilization temperature $T_{25}$ (°C) defined by the following item (A) in a temperature range of 200°C or lower, which are mixed with each other;
a step of subjecting a coated film thus coated, to a heat treatment at a temperature range that is $T_{25}$ (°C) or higher and causes no sintering of the silver particles, thereby performing volatilization of the dispersion medium; and
a step of baking the coated film thus subjected to the heat treatment, at a temperature of from 170 to 250°C under application of a pressure of from 5 to 35 MPa, thereby providing a silver sheet containing the silver particles integrated by sintering. On coating the silver paste on the substrate, the silver paste may be coated into a pattern by printing.

(A) On subjecting the silver paste to thermogravimetric analysis (TG) by heating from ambient temperature at 10°C per minute in the air, a temperature, at which the dispersion medium shows a weight reduction rate according to the following expression (2) of 25% is designated as the 25% volatilization temperature $T_{25}$ (°C) :

$$(\text{weight reduction ratio of dispersion medium (\%))} =$$

$$((\text{cumulative mass of dispersion medium having been volatilized}$$

$$\text{by heating in thermogravimetric analysis (g))} / (\text{total mass}$$

$$\text{of dispersion medium present in silver paste specimen before}$$

$$\text{subjecting to thermogravimetric analysis (g)))} \times 100 \qquad (2)$$

The particle diameter of the silver particles herein is expressed by the major axis of the primary particle. A mixture of various kinds of silver powder having various average particle diameters may be used, as far as the silver powder is formed of silver particles having a particle diameter of from 1 to 250 nm. Silver powder having an average particle diameter of from 20 to 120 nm is more preferably used.

The invention also provides a method for joining an electronic part, containing: inserting the silver sheet between an electronic part and a substrate, to which the electronic part is to be joined; and heating them to the temperature range of $T_A$ (°C) or higher and $T_B$ (°C) or lower, under application of a pressure to the electronic part and the substrate to make a contact surface pressure of the electronic part and the silver sheet of from 0.5 to 3 MPa, and preferably from 1 to 3 MPa.

Advantageous Effects of Invention

According to the invention, members to be joined to each other can be joined under a low pressure of 3 MPa or lower by using the joining material in the form of a sheet. The invention is particularly useful as a measure for joining an electronic part to a substrate.

Brief Description of Drawings

[Fig. 1] Fig. 1 is an SEM micrograph of the surface of the silver sheet obtained in Example 1.
[Fig. 2] Fig. 2 is an SEM micrograph of the surface of the silver sheet obtained in Example 5.
[Fig. 3] Fig. 3 is an SEM micrograph of the surface of the silver sheet obtained in Example 6.
[Fig. 4] Fig. 4 is an SEM micrograph of the surface of the silver sheet obtained in Example 7.
[Fig. 5] Fig. 5 is an SEM micrograph of the surface of the silver sheet obtained in Example 8.
[Fig. 6] Fig. 6 is an SEM micrograph of the surface of the silver coated film after the preliminary heat treatment obtained in Comparative Example 1.
[Fig. 7] Fig. 7 is an SEM micrograph of the surface of the silver coated film after the preliminary heat treatment obtained in Comparative Example 2.
[Fig. 8] Fig. 8 is an SEM micrograph of the surface of the silver sheet obtained after subjecting the silver sheet obtained in Example 1 to a heating test under conditions of a pressure of 1 MPa and a temperature of 300°C for 5 minutes.
[Fig. 9] Fig. 9 is TG-DTA curves of a silver paste capable of being applied to the invention (the silver paste A in Example).

Description of Embodiments

The silver sheet of the invention is inserted between members to be joined, and joins the members to be joined disposed on both sides thereof by utilizing solid phase diffusion of the silver sheet, which occurs on heating to the temperature range of "$T_A$ (°C) or higher and $T_B$ (°C) or lower" satisfying the following expression (1).

$$270 \leq T_A < T_B \leq 350 \qquad (1)$$

The silver sheet has such a feature that the pressure to be applied thereto may be as low as approximately from 0.5 to 3 MPa irrespective of the use of solid phase diffusion.

The silver sheet according to the invention is a sintered sheet formed by sintering silver powder. The silver sheet achieves joining under such a low pressure as described above since the silver sheet has the "capability of further undergoing sintering" at the temperature $T_3$ (°C) on joining, which is within the "temperature range of $T_A$ (°C) or higher and $T_B$ (°C) or lower". In other words, the sintering that is performed in the step of production of the silver sheet is terminated in an incomplete state. The silver sheet in this state has many voids thereinside. The sintering further proceeds at the heating temperature on joining, and thus the shape and the amount of the voids are largely changed only by applying a low pressure, thereby promoting active migration (diffusion) of silver atoms. Consequently, a joined portion where the members to be joined on the both sides are tightly joined to each other is provided thereby.

Whether or not the silver sheet has the "capability of further undergoing sintering" may be confirmed by subjecting the silver sheet to an experiment of heating to the "temperature range of $T_A$ (°C) or higher and $T_B$ (°C) or lower" satisfying the expression (1), as described above.

For providing a high joining strength stably in the case where members are joined under a low pressure, it is effective to reduce the surface roughness of the sheet. As a result of various investigations, the arithmetic average surface roughness Ra is desirably 0.10 $\mu$m or less for both the front and back surfaces of the sheet. The silver sheet that has Ra of 0.10 $\mu$m or less may be obtained by a pressure in the pressurized baking described later of 8 MPa or higher.

The thickness of the silver sheet is preferably from 10 to 120 $\mu$m in terms of a thickness measured with a flat head micrometer. For providing a high joining strength stably, it is effective to ensure the thickness of the sheet of 10 $\mu$m or more. The thickness is more preferably 20 $\mu$m or more. Even though the thickness is 120 $\mu$m or more, the effect of enhancing the stability of the joining strength may be saturated, and thus it is uneconomical. The thickness is more preferably 100 $\mu$m or less, and further preferably 50 $\mu$m or less.

Raw Material Silver Powder

Silver powder as a raw material of the silver sheet is preferably constituted by silver particles having a particle diameter of from 1 to 250 nm. Silver powder formed of such fine particles undergoes a sintering phenomenon at a low temperature lower than 250°C, and is significantly useful for providing a silver sheet, in which the sintering is terminated in an incomplete state, i.e., a silver sheet having the "capability of further undergoing sintering". In total consideration of the handleability, the cost, the temperature capable of starting sintering, and the like, silver powder having an average particle diameter of from 20 to 120 $\mu$m is more practically used. The particle diameter herein means the diameter of the longest part (major axis) of the particle. The shape of the particles is more preferably a spherical shape.

The raw material silver powder used may be coated with an organic protective material. The organic protective material preferably remains until the silver powder is subjected to the pressurized baking for producing the silver sheet. Accordingly, during the process until the silver powder is subjected to the pressurized baking, the organic protective material may be volatilized to some extent but preferably does not completely disappear. More specifically, the remaining ratio of the organic protective material (in terms of ratio with respect to the total mass of the initial organic protective material) is preferably 30% or more at the time when the preliminary heat treatment is completed. Examples of the organic protective material include a fatty acid, such as sorbic acid, hexanoic acid, butanoic acid and malic acid. The production method itself of the raw material silver powder is not particularly limited, and silver powder produced by a known method may be used.

Silver Paste

A dispersion medium and the silver powder are mixed to form a silver paste. At this time, an additive may be added thereto for such purposes as control of the viscosity and the like. As a result of detailed investigations by the inventors, it has been found that it is significantly important for enabling the formation of the silver sheet through pressurized baking at a low temperature that the substances constituting the dispersion medium are sufficiently removed through volatilization before the pressurized baking on producing the silver sheet. In other words, when the pressurized baking is performed in such a state that a large amount of dispersion medium is present around the silver particles, the sintering phenomenon occurring among the silver particles adjacent to each other is inhibited, which makes difficult the production of the sheet. However, it has been found that in the case where the pressurized baking is performed in such a state that the dispersion medium is sufficiently removed, the silver sheet can be constituted even at the baking temperature that is lower than 250°C, and preferably lower than 200°C.

For sufficiently removing the dispersion medium before performing the sintering at a baking temperature lower than 250°C, and preferably lower than 200°C, it is necessary to use as the dispersion medium such a substance that undergoes volatilization by a heat treatment at a low temperature, at which the sintering does not occur. However, even after the dispersion medium has been sufficiently removed, the surfaces of the respective silver particles are preferably coated with the organic protective material until being subjected to the pressurized baking. Accordingly, the substance that is used as the dispersion medium may be a substance having such a property that volatilization thereof proceeds by a heat treatment at a low temperature, at which the organic protective material of the silver particles remains. Specifically, such a dispersion medium is preferably used that has a 25% volatilization temperature $T_{25}$ (°C) defined by the aforementioned item (A) in a temperature range of 200°C or lower. A dispersion medium having $T_{25}$ in a temperature range exceeding 200°C is difficult to be sufficiently removed through volatilization in a low temperature range, in which the sintering does not occur. $T_{25}$ is preferably in a temperature range of 100°C or higher. When $T_{25}$ is lower than 100°C, the substance is liable to be volatilized under a storing environment, and the storage management of the silver paste is necessarily strictly performed.

Examples of the dispersion medium that has a 25% volatilization temperature $T_{25}$ (°C) in a range of 200°C or lower, and more preferably 100°C or higher and 200°C or lower, include 2-ethyl-1,3-hexanediol. Examples of the additive that is added to the paste for controlling the viscosity and the like include an organic substance such as 2-butoxyethoxyacetic acid and 2-methoxyethoxyacetic acid. The content of the additive in the paste is preferably 2.0% by mass or less, and more preferably 1.0% by mass or less.

Coating on Substrate

The silver paste is coated on a substrate to form a coated film. The substrate used may be a material, from which the silver sheet thus formed may be released off. Examples thereof applied include a glass substrate and an alumina substrate, having good smoothness. Depending on purposes, a substrate having a curved surface and a substrate having an uneven surface may also be used. The thickness of the coated film may be controlled to make the thickness of the silver sheet obtained after the pressurized baking within the prescribed range (described above). In consideration of the arrangement of electronic parts to be joined, the silver paste may be coated in a patterned shape by printing.

Preliminary Heat Treatment

Before subjecting to the pressurized baking, the coated film thus coated on the substrate is heated to provide a coated film, in which the dispersion medium has been sufficiently volatilized. This heat treatment in the description herein is referred to as a "preliminary heat treatment". The preliminary heat treatment is performed in a temperature range, in which the volatilization of the dispersion medium proceeds, and the sintering of the silver particles does not occur. From the standpoint of the promotion of volatilization of the dispersion medium, it is effective to use a heating temperature that is the 25% volatilization temperature $T_{25}$ (°C) or higher. When the heating temperature is lower than that temperature, a prolonged period of time may be required for the sufficient volatilization of the dispersion medium to impair the productivity, or the sufficient volatilization of the dispersion medium may be impossible. From the standpoint of preventing the sintering of the silver particles from occurring, the suitable temperature may be selected from a range of 200°C or lower in the case where no pressure is applied. In the case where the average particle diameter of the silver powder used is large as exceeding, for example, 120 nm, the temperature causing no sintering may be easily selected from a temperature range exceeding 200°C. The preliminary heat treatment temperature is preferably in a range of 250°C or lower. When the temperature is higher than the range, the sintering is liable to occur partially. If the sintering occurs in the stage of the preliminary heat treatment, it may be difficult to produce a stable sheet by the pressurized baking.

The dispersion medium is preferably removed as much as possible before the pressurized baking, but may remain slightly as far as the sheet can be formed by the pressurized baking. The conditions (including the retention temperature and the retention time) of the preliminary heat treatment capable of forming the sheet may be determined in advance by experiments depending on the kinds of the raw material silver powder and the additives, the conditions in the pressurized baking as the subsequent step, and the like. In the case where the period of time of the preliminary heat treatment for removing the dispersion medium through volatilization is too short, a large amount of organic substances derived from the dispersion medium may remain, which may make difficult the formation of the sheet, in some cases. In the case where the dispersion medium is 2-ethyl-1,3-hexanediol, for example, a suitable preliminary heat treatment condition may be found in ranges of a heating temperature of from 130 to 170°C and a heating time of from 5 to 30 minutes.

Pressurized Baking

The coated film of the silver paste, from which the substances of the dispersion medium have been sufficiently removed through volatilization after the preliminary heat treatment, is subjected to baking in a state where a pressure is applied to the surface thereof, thereby providing the silver sheet. The pressure may be applied in such a manner that the coated film is held from both sides thereof with a pair of materials that are not joined to the silver sheet in nature, such as a glass material or a ceramic material. The material for holding the coated film from one side may be the substrate having the silver paste coated thereon as it is.

The pressure is preferably in a range of from 5 to 35 MPa, and more preferably in a range of from 8 to 35 MPa. The silver sheet that has high smoothness may be obtained by increasing the pressure. The silver sheet that has an arithmetic average surface roughness Ra of 0.10 $\mu$m or less on the surface thereof is significantly useful for providing a high joining strength between the members to be joined. A pressure of 8 MPa or higher may facilitate the production of the silver sheet having Ra of 0.10 $\mu$m or less. On the other hand, an excessively increased pressure is not preferred since the process load of the pressurized baking may be increased thereby. As a result of various investigations, the pressure is preferably set in a range of 35 MPa or lower, and may be managed in a range of 25 MPa or lower, or 20 MPa or lower.

In the pressurized baking, the sintering among the silver particles is terminated in an incomplete state, thereby providing the silver sheet. In the case where the temperature of the pressurized baking is excessively higher than the temperature capable of starting the sintering of the raw material silver powder used, it may be difficult to terminate the sintering in an incomplete state, thereby failing to produce stably the silver sheet having the "capability of further undergoing sintering". As a result of various investigations, the temperature of the pressurized baking is preferably 250°C or lower in the case where the raw material silver powder used is constituted by silver particles having a particle diameter of 250 nm or less. In the case where the raw material silver powder having an average particle diameter of 120 nm or less, in particular, the temperature may be 200°C or lower. The sintering may be liable to occur due to the pressure applied, and thus there are cases where the pressurized baking can be achieved at a temperature that is equivalent to or lower than the preliminary heat treatment temperature.

In general, the suitable conditions may be determined for the heating temperature of the pressurized baking within a range of from 170 to 250°C, and more preferably from 170 to 220°C, and for the heating time within a range of from 3 to 30 minutes, and more preferably from 3 to 10 minutes.

Joining with Silver Sheet

The silver sheet thus obtained above is inserted between members to be joined, and undergoes solid phase diffusion by heating to a prescribed joining temperature in a state where a prescribed pressure is applied, thereby exhibiting the function as a joining material.

The joining is performed within a temperature range of $T_A$ (°C) or higher and $T_B$ (°C) or lower satisfying the following expression (1). The temperature range of "$T_A$ (°C) or higher and $T_B$ (°C) or lower" means the temperature range where the sintering of the silver sheet may further proceed, as described above.

$$270 \leq T_A < T_B \leq 350 \qquad\qquad (1)$$

The pressure applied on joining may be in a range of from 0.5 to 3 MPa, and more preferably in a range of from 0.8 to 2 MPa. In the case where joining through solid phase diffusion is performed with an ordinary joining material in the form of a sheet at a low temperature, for example, of approximately from 270 to 350°C, a high pressure of 10 MPa or higher has been required. The application of such a high pressure to an electronic part and the like is not preferred, and there has been frequently limitation in the purposes of the method. The silver sheet according to the invention causes the solid phase diffusion by utilizing the "capability of further undergoing sintering", and thus enables the joining under a considerably low pressure. The heating time at the temperature range of $T_A$ (°C) or higher and $T_B$ (°C) or lower on joining may be determined in a range of from 3 to 30 minutes, and more preferably in a range of from 3 to 15 minutes.

Example

Silver particle-aggregated dry powder made of spherical silver particles having an average primary particle diameter of approximately 100 nm coated with sorbic acid which is an organic protective material was prepared as raw material silver powder. The amount of metallic silver contained in the silver powder was 99.2% by mass. 2-Butoxyethoxyacetic acid was prepared as an additive for controlling the viscosity and the thixotropy. Octanediol (2-ethyl-1,3-hexanediol) was prepared as a dispersion medium.

90.5 g of the raw material silver powder (containing 89.776 g of metallic silver), 0. 95 g of the additive, and 8.55 g of the dispersion medium were mixed and then kneaded with a kneading-degassing machine (V-mini 300, produced by EME Corporation) under conditions of a revolution of 1,400 rpm and a rotation of 700 rpm, and the resulting kneaded product was subjected to a three-roll kneader (22851 Norderstedt, EXAKT Apparatebau GmbH & Co.) while controlling the gap by from 5 to 10 passes, thereby providing a silver paste. The silver paste was designated as a "silver paste A".

For comparison, silver particle-aggregated dry powder made of spherical silver particles having an average primary particle diameter of approximately 0.8 $\mu$m coated with oleic acid as an organic protective material was prepared as raw material silver powder. The amount of metallic silver contained in the silver powder was 99.62% by mass. 90.5 g of the raw material silver powder (containing 90. 156 g of metallic silver), 0.95 g of the additive, and 8.55 g of the dispersion medium were mixed, and then a silver paste was provided in the same manner as above. The silver paste was designated as a "silver paste B".

One of the silver pastes was coated on a substrate formed of flat plate glass through a metallic mask to a 13 mm square with a thickness of 70 $\mu$m by manual printing using a metallic squeegee, and subjected to a preliminary heat treatment in the air under the conditions shown in Tables 1 and 2. The preliminary heat treatment was a two-stage heat treatment with different temperature levels, except for some examples. The temperature $T_1$ (°C) of the preliminary heat treatment shown in Tables 1 and 2 means the treatment temperature corresponding to the "temperature range that is the 25% volatilization temperature $T_{25}$ (°C) or higher and causes no sintering of the silver particles" of the treatment temperatures employed in the preliminary heat treatment. The hyphen shown in the column for $T_1$ means that the preliminary heat treatment at the treatment temperature corresponding to the "temperature range that is the 25% volatilization temperature $T_{25}$ (°C) or higher and causes no sintering of the silver particles" was not performed. The coated film having been subjected to the preliminary heat treatment was held from both side thereof with a pair of flat plate glass to make a state where a pressure was applied thereto, and subjected to pressurized baking under the conditions shown in Tables 1 and 2. After completing the pressurized baking, the pair of flat plate glass was removed, and the surface roughness Ra of the surface of the coated film after the pressurized baking was measured. The results are shown in Tables 1 and 2.

In the column "Evaluation of sheet formation" in Tables 1 and 2, the cases where sintering of the silver particles was observed after the pressurized baking, and the coated film was not broken after releasing from the flat plate glass are shown by $\bigcirc$, and the other cases are shown by $\times$. In the example where a sheet was capable of being formed, the silver sheet thus formed was taken out, and Ra was also measured for the surface thereof opposite to the surface having been measured for Ra above. As a result, Ra thus measured was substantially the same as Ra on the side shown in Table 1.

In the example where a sheet was capable of being formed, a specimen cut out from the silver sheet thus obtained was held with a pair of flat plate glass to make a state where a pressure of 1 MPa was applied thereto, and subjected to a heating test of retaining at 300°C in the air for 5 minutes, and the SEM micrographs at a magnification of 30,000 before and after the heating test were compared to each other. As a result, an apparent change in shape of the voids was observed in all the silver sheets, and thus it was confirmed that the silver sheets had the "capability of undergoing further sintering".

A silicon chip having a thickness of 0.3 mm (12.5 mm square) and a copper plate having a thickness of 1 mm (30 mm square) were prepared as members to be joined. The surfaces of these materials had been subjected to silver plating. In the example where a sheet was capable of being formed, the silver sheet was inserted between the members to be joined, and subjected to the joining test under the conditions shown in Table 1. The both ends of the copper plate of the resulting joined assembly were held with pinchers, and the copper plate was bent at the center part of the 30 mm square by approximately 90°. Thereafter, the shape of the copper plate was restored to the initial shape. The area ratio of the silicon chip that remained on the copper plate thus restored to the initial shape was measured and evaluated for the joining strength by the following standard. The evaluation of $\bigcirc$ or better was designated as passed.

$\odot$: The area ratio of the remaining silicon chip was 100%.
$\bigcirc$: The area ratio of the remaining silicon chip was 80% or more and less than 100%.
$\times$: The area ratio of the remaining silicon chip was less than 80%.

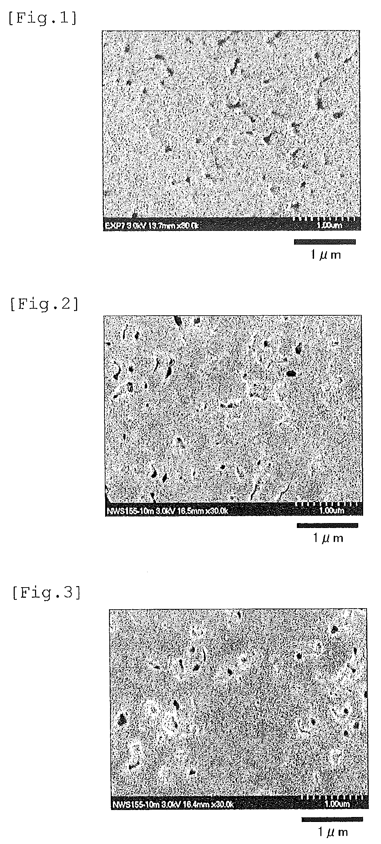

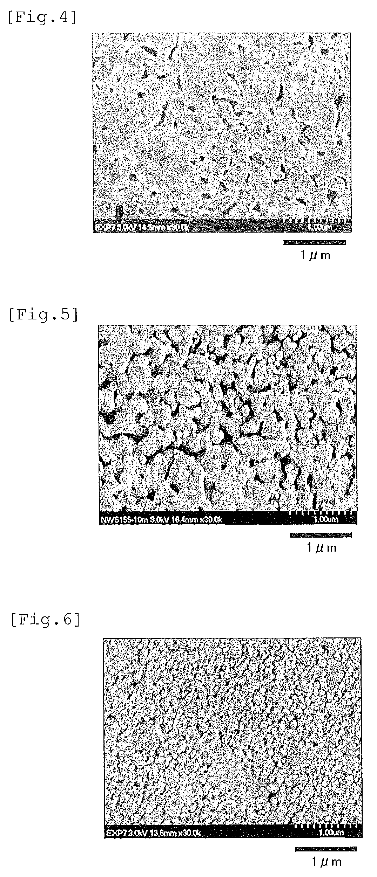

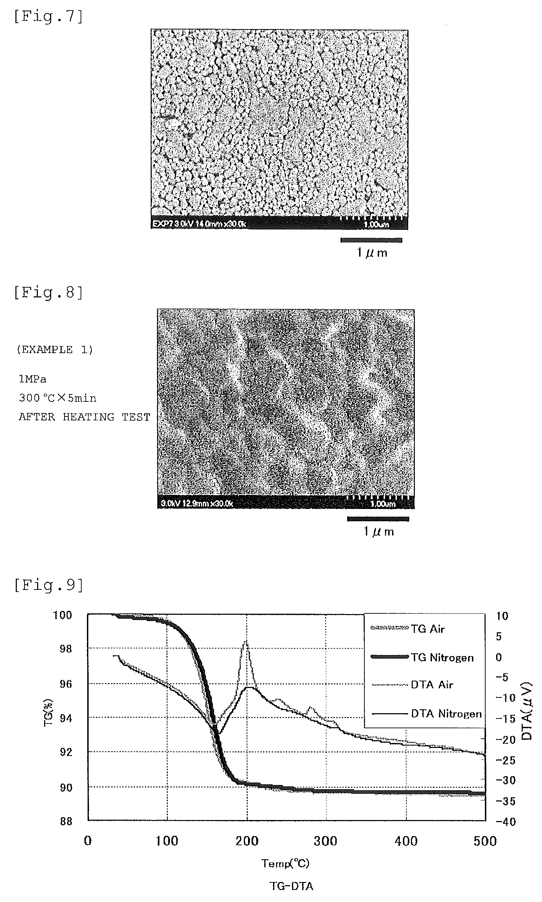

For reference, Figs. 1 to 5 show the SEM micrographs of the surfaces of the silver sheets of some of Examples. Figs. 6 and 7 show the SEM micrographs of the surface of the coated film after the pressurized baking of some of Comparative Examples, where a sheet was not formed. The corresponding figure numbers of the SEM micrographs were shown in Tables 1 and 2. Fig. 8 shows the SEM micrograph of the surface of the sheet after subjecting the silver sheet of Example 1 to a heating test at 300°C in the air for 5 minutes under application of a pressure of 1 MPa. Fig. 9 shows the TG-DTA curves of the silver paste A where the silver paste is heated from ambient temperature (25°C) to 500°C at 10°C per minute in the air or a nitrogen atmosphere. The silver paste A has a content of the dispersion medium of 8.55% by mass, and thus the amount of the dispersion medium having been volatilized when the "weight reduction rate of the dispersion medium (%)" in the expression (2) is 25% is $8.55 \times (25/100) \approx 2.14$ g per 100 g of the silver paste. In the TG curve in Fig. 9, it is considered that the weight change in the range of 170°C or lower substantially corresponds to the volatilization of the dispersion medium, and therefore it is apparent that the 25% volatilization temperature $T_{25}$ of the silver paste A is in a range between 100°C and 150°C.

Table 1

| Example No. | Kind of silver paste | Preliminary heat treatment | | | | | Pressurized baking | | | Coated film after pressurized baking | | | Joining test | | | |
| | | First stage | | Second staae | | $T_1$ (°C) | Pressure (MPa) | Heating condition | | Ra ($\mu$m) | Evaluation of sheet formation | SEM micrograph | Pressure (MPa) | Heating condition | | Evaluation of joining strength |
| | | Temp. (°C) | Time (min) | Temp. (°C) | Time (min) | | | Temp. $T_2$ (°C) | Time (min) | | | | | Temp. $T_3$ (°C) | Time (min) | |
|---|---|---|---|---|---|---|---|---|---|---|---|---|---|---|---|---|
| Example 1 | A | 100 | 10 | 150 | 10 | 150 | 20 | 180 | 5 | 0.059 | ○ | Fig. 1 | 2 | 300 | 5 | ⊙ |
| Example 2 | A | 100 | 10 | 150 | 10 | 150 | 20 | 180 | 5 | 0.058 | ○ | | 1 | 300 | 5 | ⊙ |
| Example 3 | A | 100 | 10 | 150 | 10 | 150 | 30 | 180 | 5 | 0.059 | ○ | | 2 | 300 | 5 | ⊙ |
| Example 4 | A | 100 | 10 | 150 | 10 | 150 | 30 | 180 | 5 | 0.062 | ○ | | 1 | 300 | 5 | ⊙ |
| Example 5 | A | 150 | 10 | - | - | 150 | 20 | 180 | 5 | 0.061 | ○ | Fig. 2 | 1 | 300 | 5 | ⊙ |
| Example 6 | A | 150 | 10 | 100 | 10 | 150 | 20 | 180 | 5 | 0.063 | ○ | Fig. 3 | 1 | 300 | 5 | ⊙ |
| Example 7 | A | 100 | 10 | 150 | 10 | 150 | 10 | 180 | 5 | 0.071 | ○ | Fig. 4 | 1 | 300 | 5 | ⊙ |
| Example 8 | A | 100 | 10 | 150 | 10 | 150 | 5 | 180 | 5 | 0.279 | ○ | Fig. 5 | 1 | 300 | 5 | ○ |

Table 2

| Example No. | Kind of silver paste | Preliminary heat treatment | | | | | Pressurized baking | | | Coated film after pressurized baking | | | Joining test | | | |
|---|---|---|---|---|---|---|---|---|---|---|---|---|---|---|---|---|
| | | First stage | | Second stage | | $T_1$ (°C) | Pressure (MPa) | Heating condition | | Ra (μm) | Evaluation of sheet formation | SEM micrograph | Pressure (MPa) | Heating condition | | Evaluation of joining strength |
| | | Temp. (°C) | Time (min) | Temp. (°C) | Time (min) | | | Temp. $T_2$ (°C) | Time (min) | | | | | Temp. $T_3$ (°C) | Time (min) | |
| Comparative Example 1 | A | 100 | 10 | - | - | - | 10 | 180 | 5 | 0.421 | × | Fig. 6 | - | - | - | - |
| Comparative Example 2 | A | 100 | 10 | - | - | - | 20 | 180 | 5 | 0.406 | × | Fig. 7 | - | - | - | - |
| Comparative Example 3 | A | 100 | 10 | 150 | 10 | 150 | - | - | - | 0.486 | × | - | - | - | - | - |
| Comparative Example 4 | A | 100 | 10 | - | - | - | - | - | - | 0.482 | × | - | - | - | - | - |
| Comparative Example 5 | B | 100 | 10 | 150 | 10 | 150 | 20 | 180 | 5 | 6.338 | × | - | - | - | - | - |
| Comparative Example 6 | B | 100 | 10 | 150 | 10 | 150 | 30 | 180 | 5 | 5.458 | × | - | - | - | - | - |

In Examples, the preliminary heat treatment was performed at the temperature $T_1$ (°C) that was the 25% volatilization temperature $T_{25}$ (°C) or higher and caused no sintering of the silver particles. It is considered that the dispersion medium in the paste was substantially removed through volatilization by the preliminary heat treatment. As a result, the sheet was able to be formed. It is also considered that most of the organic protective material on the surface of the silver particles and the organic substance as the additive were substantially removed through volatilization at the heat baking temperature $T_2$ (°C). The silver sheets thus obtained were determined to have the "capability of further undergoing sintering". It was confirmed that the silver sheet can be used for diffusion joining at a low pressure. It was also confirmed that the enhancement of the smoothness on the surface of the silver sheet was effective for providing a high joining strength (comparison between Example 8 and the other Examples).

In Comparative Examples 1 and 2, on the other hand, the preliminary heat treatment at a temperature that was the 25% volatilization temperature $T_{25}$ (°C) or higher was not performed, and thus the dispersion medium in the paste was insufficiently removed through volatilization, thereby failing to form a sheet by the pressurized baking. In Comparative Examples 3 and 4, the pressurized baking was not performed, thereby failing to form a sheet. In Comparative Examples 5 and 6, raw material silver powder formed of silver particles having a particle diameter exceeding 250 nm was used, and thus the sintering did not proceed at the pressurized baking temperature according to the invention, thereby failing to form a sheet.

**Claims**

1. A joining silver sheet comprising silver particles having a particle diameter of from 1 to 250 nm integrated by sintering, and having a capability of further undergoing sintering on heating and retaining the silver sheet at a temperature range of "$T_A$ (°C) or higher and $T_B$ (°C) or lower" satisfying the following expression (1):

$$270 \leq T_A < T_B \leq 350 \qquad\qquad (1)$$

2. The joining silver sheet according to claim 1, wherein both surfaces of the sheet each have an arithmetic average surface roughness Ra of 0.10 $\mu$m or less.

3. The joining silver sheet according to claim 1 or 2, wherein the silver sheet has a thickness of from 10 to 120 $\mu$m in terms of a thickness measured with a flat head micrometer.

4. The joining silver sheet according to any one of claims 1 to 3, wherein the silver sheet has a projected shape viewed in a thickness direction that shows a pattern formed by printing.

5. A method for manufacturing a joining silver sheet, comprising:

   a step of coating, on a substrate, a silver paste containing silver powder containing silver particles having a particle diameter of from 1 to 250 nm, and a dispersion medium having a 25% volatilization temperature $T_{25}$ (°C) defined by the following item (A) in a temperature range of 200°C or lower, which are mixed with each other;
   a step of subjecting a coated film thus coated, to a heat treatment at a temperature range that is $T_{25}$ (°C) or higher and causes no sintering of the silver particles, thereby performing volatilization of the dispersion medium; and
   a step of baking the coated film thus subjected to the heat treatment, at a temperature of from 170 to 250°C under application of a pressure of from 5 to 35 MPa, thereby providing a silver sheet containing the silver particles integrated by sintering,

   (A) on subjecting the silver paste to thermogravimetric analysis (TG) by heating from ambient temperature at 10°C per minute in the air, a temperature, at which the dispersion medium shows a weight reduction ratio according to the following expression (2) of 25% is designated as the 25% volatilization temperature $T_{25}$ (°C) :

$$(\text{weight reduction ratio of dispersion medium } (\%)) =$$

$$((\text{cumulative mass of dispersion medium having been volatilized}$$

$$\text{by heating in thermogravimetric analysis } (g)) / (\text{total mass}$$

$$\text{of dispersion medium present in silver paste specimen before}$$

$$\text{subjecting to thermogravimetric analysis } (g))) \times 100 \qquad (2)$$

6. The method for manufacturing a joining silver sheet according to claim 5, wherein on coating the silver paste on the substrate, the silver paste is coated into a pattern by printing.

7. A method for joining an electronic part, comprising: inserting the silver sheet according to any one of claims 1 to 4 between an electronic part and a substrate, to which the electronic part is to be joined; and heating them to the temperature range of $T_A$ (°C) or higher and $T_B$ (°C) or lower, under application of a pressure to the electronic part and the substrate to make a contact surface pressure of the electronic part and the silver sheet of from 0.5 to 3 MPa.

[Fig.1]

1 μm

[Fig.2]

1 μm

[Fig.3]

1 μm

[Fig.4]

1 μm

[Fig.5]

1 μm

[Fig.6]

1 μm

[Fig.7]

1 μm

[Fig.8]

(EXAMPLE 1)

1MPa
300 °C×5min
AFTER HEATING TEST

1 μm

[Fig.9]

TG-DTA

## INTERNATIONAL SEARCH REPORT

| | International application No. |
| | PCT/JP2014/076660 |

**A. CLASSIFICATION OF SUBJECT MATTER**
*H01B5/02*(2006.01)i, *B22F1/00*(2006.01)i, *B22F3/10*(2006.01)i, *B22F5/10*
(2006.01)i, *B22F9/00*(2006.01)i, *H01B5/14*(2006.01)i, *H01B13/00*(2006.01)i,
*H01L21/52*(2006.01)i, *B22F1/02*(2006.01)n
According to International Patent Classification (IPC) or to both national classification and IPC

**B. FIELDS SEARCHED**

Minimum documentation searched (classification system followed by classification symbols)
H01B5/02, B22F1/00, B22F3/10, B22F5/10, B22F9/00, H01B5/14, H01B13/00,
H01L21/52, B22F1/02

Documentation searched other than minimum documentation to the extent that such documents are included in the fields searched
| Jitsuyo Shinan Koho | 1922-1996 | Jitsuyo Shinan Toroku Koho | 1996-2014 |
| Kokai Jitsuyo Shinan Koho | 1971-2014 | Toroku Jitsuyo Shinan Koho | 1994-2014 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 63-186434 A (Siemens AG.),<br>02 August 1988 (02.08.1988),<br>entire text; all drawings<br>& US 4856185 A  & EP 275433 A1<br>& DE 3777995 A | 1-4,7 |
| A | JP 2008-212976 A (Toda Kogyo Corp.),<br>18 September 2008 (18.09.2008),<br>claims 1, 5<br>(Family: none) | 1-7 |
| A | JP 2007-83288 A (Harima Chemicals, Inc.),<br>05 April 2007 (05.04.2007),<br>paragraphs [0023], [0066], [0074]<br>(Family: none) | 1-7 |

| ☒ Further documents are listed in the continuation of Box C. | ☐ See patent family annex. |

| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>    22 December 2014 (22.12.14) | Date of mailing of the international search report<br>    06 January 2015 (06.01.15) |
| Name and mailing address of the ISA/<br>    Japan Patent Office | Authorized officer |
| Facsimile No. | Telephone No. |

Form PCT/ISA/210 (second sheet) (July 2009)

**INTERNATIONAL SEARCH REPORT**

International application No.

PCT/JP2014/076660

C (Continuation). DOCUMENTS CONSIDERED TO BE RELEVANT

| Category* | Citation of document, with indication, where appropriate, of the relevant passages | Relevant to claim No. |
|---|---|---|
| A | JP 2005-205696 A (Ebara Corp.),<br>04 August 2005 (04.08.2005),<br>entire text; all drawings<br>(Family: none) | 1-7 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2012169076 A